# EUROPEAN PATENT SPECIFICATION

(11) **EP 3 089 356 B1**
(45) Date of publication and mention of the grant of the patent: **06.01.2021**
(21) Application number: 14873748.9
(22) Date of filing: 16.09.2014
(51) Int. Cl.: H02S 40/34, H01L 31/05

(54) **SOLAR CELL MODULE**
SOLARZELLENMODUL
MODULE DE CELLULE SOLAIRE

(30) Priority: 27.12.2013 JP 2013271977
(43) Date of publication of application: 02.11.2016
(73) Proprietor: Panasonic Intellectual Property Management Co., Ltd., Osaka-shi, Osaka 540-6207 (JP)
(72) Inventor: ISHII, Yousuke, Osaka-shi, Osaka 540-6207 (JP); NAKAMURA, Kei, Osaka-shi, Osaka 540-6207 (JP); YAMADA, Hiroyuki, Osaka-shi, Osaka 540-6207 (JP); OKAMOTO, Shingo, Osaka-shi, Osaka 540-6207 (JP); YOSHIMINE, Yukihiro, Osaka-shi, Osaka 540-6207 (JP)
(74) Representative: Müller-Boré & Partner Patentanwälte PartG mbB
(86) International application number: PCT/JP2014/074396
(87) International publication number: WO 2015/098203

(56) References cited:
- EP-A1- 2 256 825
- CN-U- 201 584 420
- JP-A- H10 256 584
- JP-A- 2000 101 122
- JP-A- 2003 282 916
- JP-U- 3 168 519
- US-A1- 2013 037 077
- US-A1- 2013 037 077

## Description

### [Technical Field]

The present invention relates to a solar cell module.

### [Background Art]

A solar cell module includes solar cell sets each connected to a bypass diode in parallel. When a failure, for example, occurs in one solar cell set, this solar cell set is electrically diverted by the bypass diode. This prevents application of a reverse bias voltage to the solar cell set in which the failure, for example, has occurred, and causes the remaining solar cell sets to generate power. Such a bypass diode is generally disposed in a terminal box provided to a solar cell module.

According to Patent Literature 1 (PTL 1), a plurality of terminal boxes are provided to a solar cell module, and one bypass diode is disposed in each of the terminal boxes, so as to suppress a rise in the temperature inside the terminal boxes caused by the heat generated by a plurality of bypass diodes. It is to be noted that the solar cell set described in PTL 1 corresponds to a solar cell subgroup according to the embodiments described later.

According to Patent Literature 2 (PTL 2), a solar module having multiple junction boxes is provided, including solar panels, which are series-connected in series via tabbing ribbons and junction boxes.

According to Patent Literature 3 (PTL 3), a solar module with a plurality of junction boxes is disclosed, which comprises a plurality of solar battery units and a plurality of junction boxes, wherein each solar battery unit comprises a plurality of solar batteries sharing a junction box with one outputting current.

### [Citation List]

### [Patent Literature]

[PTL 1]
   Japanese Unexamined Patent Application Publication No. 2010-165993
[PTL 2]
   US Patent Application Publication No. US 2013/0037077 A1
[PTL 3]
   Chinese Patent Application Publication No. CN 201 584 420 U

### [Summary of Invention]

### [Technical Problem]

The solar cell module disclosed in PTL 1 performs maximum power point tracking (MPPT) control to output generated power. The MPPT control enables adjustment of the current and voltage values of the solar cell module in such a manner that even when the condition of incident light changes, a maximum amount of power generation can be ensured under the changed condition.

When, while the MPPT control is performed, the amount of power generation notably decreases due to, for example, a portion of the solar cells of a solar cell subgroup going into the shade, a reverse bias voltage from the other solar cells is applied to the in-shade solar cells. At this time, the solar cell subgroup which has gone into the shade does not output power. The greater the number of solar cells which are electrically connected in series in a solar cell subgroup which is connected in parallel to one bypass diode, the greater the number of solar cells which become unable to contribute to the output of the solar cell module when they go into the shade, thus resulting in a decrease in the output of the solar cell module. In view of this, one may consider dividing each solar cell subgroup into smaller solar cell subgroups in order to reduce the number of solar cells which are electrically connected in series.

Increasing the number of solar cell subgroups in the solar cell module, however, increases the number of line members used for electrically connecting the solar cell subgroups to one another, thus causing a problem of an increase in the area of the solar cell module.

It is an object of the present invention to provide a solar cell module which can increase the number of solar cell subgroups while suppressing an increase in the area of the solar cell module.

### [Solution to Problem]

A solar cell module according to an aspect of the present invention is a solar cell module including: a first solar cell group including a plurality of solar cells connected by a line member;
a second solar cell group including a plurality of solar cells connected by a line member; a front surface member disposed on a front surface side of the first solar cell group and the second solar cell group; a back surface member disposed on a back surface side of the first solar cell group and the second solar cell group; one or more first terminal boxes disposed on a back surface side of the back surface member; one or more second terminal boxes disposed on the back surface side of the back surface member; and an external line disposed on the back surface side of the back surface member and electrically connecting at least one first terminal box among the one or more first terminal boxes and at least one second terminal box among the one or more second terminal boxes.

### [Advantageous Effects of Invention]

The present invention can increase the number of solar cell subgroups while suppressing an increase in the area of the solar cell module.

### [Brief Description of Drawings]

[FIG. 1]

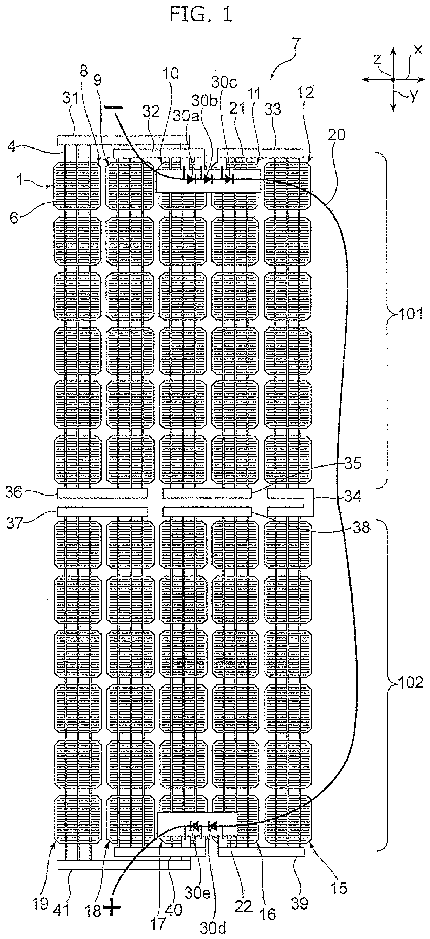

   FIG. 1 is a schematic plan view of a solar cell module according to Embodiment 1.
[FIG. 2]

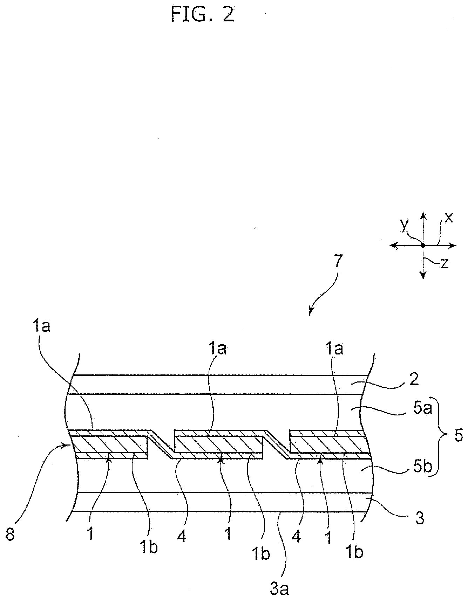

   FIG. 2 is a schematic cross-sectional view of a solar cell module according to Embodiment 1.
[FIG. 3]

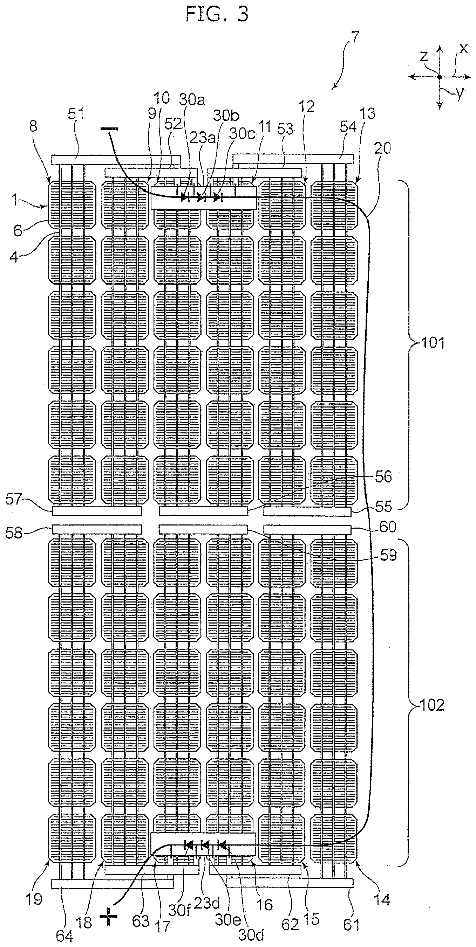

   FIG. 3 is a schematic plan view of a solar cell module according to Example 2, not being part of the invention.
[FIG. 4]

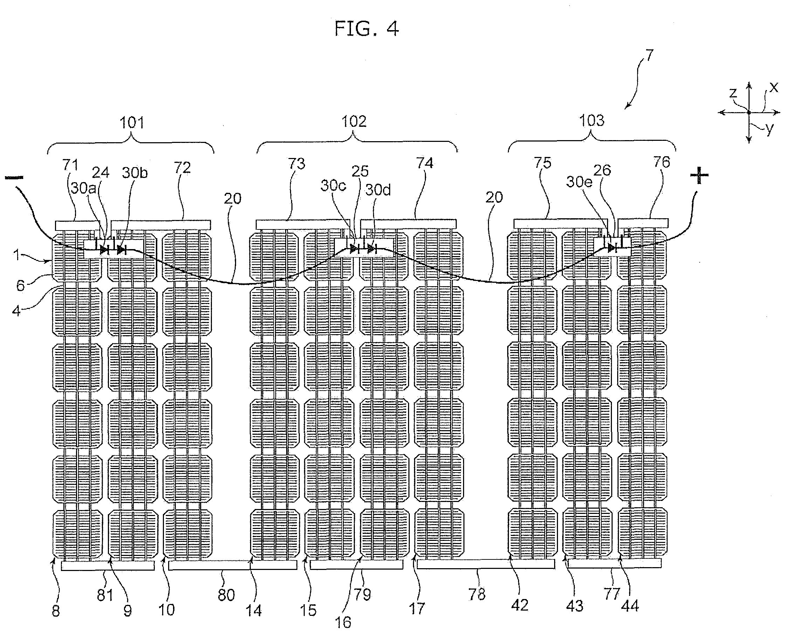

   FIG. 4 is a schematic plan view of a solar cell module according to Embodiment 3.
[FIG. 5]

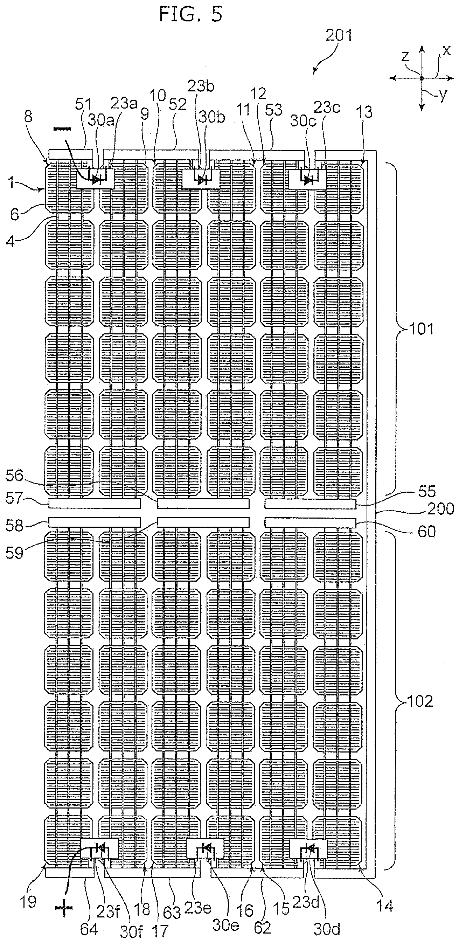

   FIG. 5 is a schematic plan view of a solar cell module according to a comparative example.

### [Description of Embodiments]

Hereinafter, a preferable embodiment will be described. The following embodiment, however, is a mere example and the present invention is not limited to this embodiment. Furthermore, in the drawings, the same reference signs may refer to elements having substantially the same function.

### [Embodiment 1]

FIG. 1 is a schematic plan view of a solar cell module according to Embodiment 1. A solar cell module 7 according to the present embodiment includes a first solar cell group 101 and a second solar cell group 102. The first solar cell group 101 includes five first solar cell strings 8, 9, 10, 11, and 12. The second solar cell group 102 includes five second solar cell strings 15, 16, 17, 18, and 19. Accordingly, the first solar cell group 101 includes an odd number of first solar cell strings and the second solar cell group 102 includes an odd number of second solar cell strings. The first solar cell strings 8 and 9 form one solar cell subgroup. Likewise, the first solar cell strings 10 and 11 form a solar cell subgroup, the first solar cell string 12 and the second solar cell string 15 form a solar cell subgroup, the second solar cell strings 16 and 17 form a solar cell subgroup, and the second solar cell strings 18 and 19 form a solar cell subgroup.

Each solar cell string is configured by electrically connecting a plurality of solar cells 1 arrayed in the y direction, with first line members 4. Finger electrodes 6 are formed on the front surface and the back surface of each solar cell 1. The first line members 4 are electrically connected with the finger electrodes 6. Bus bar electrodes may be provided in a direction intersecting the finger electrodes 6 to be electrically connected with the finger electrodes 6. In the case of providing the bus bar electrodes, the bus bar electrodes and the first line members 4 are electrically connected.

FIG. 2 is a schematic cross-sectional view of the solar cell module according to Embodiment 1. FIG. 2 illustrates a schematic cross-sectional view of the first solar cell string 8 along the first line members 4. As illustrated in FIG. 2, each of the first line members 4 is disposed to electrically connect the finger electrode 6 disposed on a back surface 1b of one of two adjacent solar cells 1 and the finger electrode 6 disposed on a front surface 1a of the other one of the adjacent solar cells 1. It is to be noted that FIG. 2 omits illustration of the finger electrode 6 on the back surface 1b and the finger electrode 6 on the front surface 1a. For the other first solar cell strings 9, 10, 11, and 12 and the second solar cell strings 15, 16, 17, 18, and 19 too, the first line members 4 electrically connect the solar cells 1 in the same manner as for the first solar cell string 8.

A transparent front surface member 2 is disposed on the front surface 1a side of the solar cells 1. In the present embodiment, the front surface 1a of the solar cells 1 is the light receiving surface. The transparent front surface member 2 is formed from glass, for example. A back surface member 3 is disposed on the back surface 1b side of the solar cells 1. The back surface member 3 is formed from a resin, for example. The front surface 1a side of the solar cells 1 is the front surface side of the first solar cell group 101 and the second solar cell group 102. Similarly, the back surface 1b side of the solar cells 1 is the back surface side of the first solar cell group 101 and the second solar cell group 102.

A filler layer 5 for sealing the solar cells 1 is disposed between the front surface member 2 and the back surface member 3. The filler layer 5 is formed from, for example, crosslinking resin such as an ethylene-vinyl acetate copolymer (EVA) or olefinic non-crosslinking resin. The filler layer 5 includes a filler layer 5a on the front surface member 2 side and a filler layer 5b on the back surface member 3 side. The filler layer 5b may include a reflecting member for reflecting light entered from the front surface member 2 side. For example, the filler layer 5b may include a white pigment such as titanium oxide as the reflecting member.

As illustrated in FIG. 1, the first solar cell group 101 is configured by electrically connecting the five first solar cell strings 8, 9, 10, 11, and 12 arrayed i n the x direction, with second line members 31, 32, 33, 35, and 36. The second solar cell group 102 is configured by electrically connecting five second solar cell strings 15, 16, 17, 18, and 19 arrayed in the x direction, with second line members 37, 38, 39, 40, and 41. Accordingly, in the present embodiment, the first solar cell group 101 includes a plurality of first solar cell strings each of which includes a plurality of solar cells connected by the first line members 4 for the first solar cell group and which are connected by the second line members for the first solar cell group. Similarly, the second solar cell group 102 includes a plurality of second solar cell strings each of which includes a plurality of solar cells connected by the first line members 4 for the second solar cell group and which are connected by the second line members for the second solar cell group.

The first solar cell string 12 located at one end of the first solar cell group 101 in the x direction and the second solar cell string 15 located at one end of the second solar cell group 102 in the x direction are electrically connected by a third line member 34. Accordingly, in the present embodiment, the first solar cell group 101 includes an odd number of first solar cell strings and the second solar cell group 102 includes an odd number of second solar cell strings, and one of the first solar cell strings which is located at one end and one of the second solar cell strings which is located at the same end are connected by a third line member.

One end of the first solar cell string 8 in the y direction is electrically connected to the second line member 31 by the first line members 4. The other end of the first solar cell string 8 in the y direction is electrically connected to the second line member 36 by the first line members 4. One end of the first solar cell string 9 in the y direction is electrically connected to the second line member 32 by the first line members 4. The other end of the first solar cell string 9 in the y direction is electrically connected to the second line member 36 by the first line members 4.

One end of the first solar cell string 10 in the y direction is electrically connected to the second line member 32 by the first line members 4. The other end of the first solar cell string 10 in the y direction is electrically connected to the second line member 35 by the first line members 4. One end of the first solar cell string 11 in the y direction is electrically connected to the second line member 33 by the first line members 4. The other end of the first solar cell string 11 in the y direction is electrically connected to the second line member 35 by the first line members 4.

One end of the first solar cell string 12 in the y direction is electrically connected to the second line member 33 by the first line members 4. The other end of the first solar cell string 12 in the y direction is electrically connected to the third line member 34 by the first line members 4. One end of the second solar cell string 15 in the y direction is electrically connected to the third line member 34 by the first line members 4. The other end of the second solar cell string 15 in the y direction is electrically connected to the second line member 39 by the first line members 4.

One end of the second solar cell string 16 in the y direction is electrically connected to the second line member 38 by the first line members 4. The other end of the second solar cell string 16 in the y direction is electrically connected to the second line member 39 by the first line members 4. One end of the second solar cell string 17 in the y direction is electrically connected to the second line member 38 by the first line members 4. The other end of the second solar cell string 17 in the y direction is electrically connected to the second line member 40 by the first line members 4.

One end of the second solar cell string 18 in the y direction is electrically connected to the second line member 37 by the first line members 4. The other end of the second solar cell string 18 in the y direction is electrically connected to the second line member 40 by the first line members 4. One end of the second solar cell string 19 in the y direction is electrically connected to the second line member 37 by the first line members 4. The other end of the second solar cell string 19 in the y direction is electrically connected to the second line member 41 by the first line members 4.

A first terminal box 21 and a second terminal box 22 are disposed on the back surface 3a side of the back surface member 3 (see FIG. 2). The first terminal box 21 is disposed at a position overlapping the first solar cell group 101. The second terminal box 22 is disposed at a position overlapping the second solar cell group 102. The first terminal box 21 and the second terminal box 22 are each disposed at a position overlapping at least one solar cell 1 located at the periphery of the solar cell module 7.

The first terminal box 21 includes bypass diodes 30a, 30b, and 30c. The second terminal box 22 includes bypass diodes 30d and 30e. Accordingly, in the present embodiment, at least one of the first terminal box 21 and the second terminal box 22 includes one or more bypass diodes. Furthermore, at least one of the first terminal box 21 and the second terminal box 22 includes a plurality of bypass diodes.

The bypass diode 30a is electrically connected between the second line member 31 and the second line member 32. Accordingly, the bypass diode 30a is electrically connected in parallel to the solar cell subgroup formed by the first solar cell strings 8 and 9 which are connected in series via the second line member 36. The bypass diode 30b is electrically connected between the second line member 32 and the second line member 33. Accordingly, the bypass diode 30b is electrically connected in parallel to the solar cell subgroup formed by the first solar cell strings 10 and 11 which are connected in series via the second line member 35.

The bypass diode 30d is electrically connected between the second line member 39 and the second line member 40. Accordingly, the bypass diode 30d is electrically connected in parallel to the solar cell subgroup formed by the second solar cell strings 16 and 17 which are connected in series via the second line member 38. The bypass diode 30e is electrically connected between the second line member 40 and the second line member 41. Accordingly, the bypass diode 30e is electrically connected in parallel to the solar cell subgroup formed by the second solar cell strings 18 and 19 which are connected in series via the second line member 37.

An external line 20 is disposed to connect the first terminal box 21 and the second terminal box 22. The external line 20 is disposed on the back surface 3a side of the back surface member 3 (see FIG. 2). The bypass diode 30c has a negative terminal electrically connected to the second line member 33 and a positive terminal electrically connected to one end of the external line 20. The other end of the external line 20 is connected to the negative terminal of the bypass diode 30d included in the second terminal box 22. Accordingly, the bypass diode 30c is electrically connected in parallel to the solar cell subgroup formed by the first solar cell string 12 and the second solar cell string 15 which are connected in series via the third line member 34. The solar cell subgroup formed by the first solar cell string 12 and the second solar cell string 15 is disposed across the first solar cell group 101 and the second solar cell group 102. The solar cell subgroup disposed across the first solar cell group 101 and the second solar cell group 102 is connected in parallel to the bypass diode 30c of the first terminal box 21 via the external line 20.

The bypass diode 30a has a negative terminal electrically connected to the second line member 31 and a positive terminal electrically connected to the second line member 32. The bypass diode 30b has a negative terminal electrically connected to the second line member 32 and a positive terminal electrically connected to the second line member 33. The bypass diode 30d has a negative terminal electrically connected to the second line member 39 and a positive terminal electrically connected to the second line member 40. The bypass diode 30e has a negative terminal electrically connected to the second line member 40 and a positive terminal electrically connected to the second line member 41. Accordingly, each bypass diode is connected in such a manner that the solar cell string connected in parallel to the bypass diode does not receive application of a reverse bias voltage from the other solar cell strings.

In the present embodiment, since the solar cell module 7 is divided into the first solar cell group 101 and the second solar cell group 102 in the y direction, the number of solar cells of solar cell strings connected in parallel to one bypass diode is 12. In the case of not dividing the solar module 7 into the first solar cell group 101 and the second solar cell group 102, for example, in the case of connecting the first solar cell string 8 and the second solar cell string 19 in series with the first line members 4 and connecting the first solar cell string 9 and the second solar cell string 18 in series with the first line members 4, the number of solar cells of the solar cell strings connected in parallel to the bypass diode 30a is 24. In comparison to this case, the present embodiment can reduce the number of solar cells of solar cell strings connected in parallel to a bypass diode. Consequently, it is possible to reduce the number of solar cells which become unable to contribute to the output of the solar cell module when, for example, a portion of the solar cells of the solar cell groups go into the shade and thus cannot generate power. It is therefore possible to suppress a decrease in the output of the solar cell module.

Furthermore, in the present embodiment, since the external line 20 electrically connects the first terminal box 21 and the second terminal box 22, there is no need to make a space for disposing a new line member in the region interposed between the front surface member 2 and the back surface member 3. It is therefore possible to suppress an increase in the area of the solar cell module.

The present embodiment is described as a representative example of an embodiment in the case where the first solar cell group 101 includes an odd number of first solar cell strings and the second solar cell group 102 includes an odd number of second solar cell strings. For example, even in the case where the first solar cell group 101 includes seven first solar cell strings and the second solar cell group 102 includes seven second solar cell strings, the first solar cell string and the second solar cell string which are located at one end in the x direction can be connected by the third line member in the same manner as in the present embodiment.

### [Example 2]

FIG. 3 is a schematic plan view of a solar cell module according to Example 2, not being part of the invention. A solar cell module 7 according to the present embodiment includes a first solar cell group 101 and a second solar cell group 102. The first solar cell group 101 according to the present embodiment includes six first solar cell strings 8, 9, 10, 11, 12, and 13. The second solar cell group 102 includes six second solar cell strings 14, 15, 16, 17, 18, and 19.

One end of the first solar cell string 8 in the y direction is electrically connected to a second line member 51 by first line members 4. The other end of the first solar cell string 8 in the y direction is electrically connected to a second line member 57 by the first line members 4. One end of the first solar cell string 9 in the y direction is electrically connected to a second line member 52 by the first line members 4. The other end of the first solar cell string 9 in the y direction is electrically connected to the second line member 57 by the first line members 4.

One end of the first solar cell string 10 in the y direction is electrically connected to the second line member 52 by the first line members 4. The other end of the first solar cell string 10 in the y direction is electrically connected to a second line member 56 by the first line members 4. One end of the first solar cell string 11 in the y direction is electrically connected to a second line member 53 by the first line members 4. The other end of the first solar cell string 11 in the y direction is electrically connected to the second line member 56 by the first line members 4.

One end of the first solar cell string 12 in the y direction is electrically connected to the second line member 53 by the first line members 4. The other end of the first solar cell string 12 in the y direction is electrically connected to a second line member 55 by the first line members 4. One end of the first solar cell string 13 in the y direction is electrically connected to a second line member 54 by the first line members 4. The other end of the first solar cell string 13 in the y direction is electrically connected to the second line member 55 by the first line members 4.

One end of the second solar cell string 14 in the y direction is electrically connected to a second line member 60 by the first line members 4. The other end of the second solar cell string 14 in the y direction is electrically connected to a second line member 61 by the first line members 4. One end of the second solar cell string 15 in the y direction is electrically connected to the second line member 60 by the first line members 4. The other end of the second solar cell string 15 in the y direction is electrically connected to a second line member 62 by the first line members 4.

One end of the second solar cell string 16 in the y direction is electrically connected to a second line member 59 by the first line members 4. The other end of the second solar cell string 16 in the y direction is electrically connected to the second line member 62 by the first line members 4. One end of the second solar cell string 17 in the y direction is electrically connected to the second line member 59 by the first line members 4. The other end of the second solar cell string 17 in the y direction is electrically connected to a second line member 63 by the first line members 4.

One end of the second solar cell string 18 in the y direction is electrically connected to a second line member 58 by the first line members 4. The other end of the second solar cell string 18 in the y direction is electrically connected to the second line member 63 by the first line members 4. One end of the second solar cell string 19 in the y direction is electrically connected to the second line member 58 by the first line members 4. The other end of the second solar cell string 19 in the y direction is electrically connected to a second line member 64 by the first line members 4.

A first terminal box 23a and a second terminal box 23d are disposed on the back surface 3a side of the back surface member 3 (see FIG. 2). The first terminal box 23a is disposed at a position overlapping the first solar cell group 101. The second terminal box 23d is disposed at a position overlapping the second solar cell group 102. The first terminal box 23a and the second terminal box 23d are each disposed at a position overlapping at least one solar cell 1 located at the periphery of the solar cell module 7.

The first terminal box 23a includes bypass diodes 30a, 30b, and 30c. The second terminal box 23d includes bypass diodes 30d, 30e, and 30f. Accordingly, in the present embodiment too, at least one of the first terminal box 23a and the second terminal box 23d includes one or more bypass diodes. Furthermore, at least one of the first terminal box 23a and the second terminal box 23d includes a plurality of bypass diodes.

The bypass diode 30a is electrically connected between the second line member 51 and the second line member 52. Accordingly, the bypass diode 30a is electrically connected in parallel to the solar cell subgroup formed by the first solar cell strings 8 and 9 which are connected in series via the second line member 57. The bypass diode 30b is electrically connected between the second line member 52 and the second line member 53. Accordingly, the bypass diode 30b is electrically connected in parallel to the solar cell subgroup formed by the first solar cell strings 10 and 11 which are connected in series via the second line member 56. The bypass diode 30c is electrically connected between the second line member 53 and the second line member 54. Accordingly, the bypass diode 30c is electrically connected in parallel to the solar cell subgroup formed by the first solar cell strings 12 and 13 which are connected in series via the second line member 55.

The bypass diode 30d is electrically connected between the second line member 61 and the second line member 62. Accordingly, the bypass diode 30d is electrically connected in parallel to the solar cell subgroup formed by the second solar cell strings 14 and 15 which are connected in series via the second line member 60. The bypass diode 30e is electrically connected between the second line member 62 and the second line member 63. Accordingly, the bypass diode 30e is electrically connected in parallel to the solar cell subgroup formed by the second solar cell strings 16 and 17 which are connected in series via the second line member 59. The bypass diode 30f is electrically connected between the second line member 63 and the second line member 64. Accordingly, the bypass diode 30f is electrically connected in parallel to the solar cell subgroup formed by the second solar cell strings 18 and 19 which are connected in series via the second line member 58.

An external line 20 is disposed to connect the first terminal box 23a and the second terminal box 23d. The external line 20 is disposed on the back surface 3a side of the back surface member 3 (see FIG. 2). One end of the external line 20 is connected to the bypass diode 30c of the first terminal box 23a. The other end of the external line 20 is connected to the bypass diode 30d of the second terminal box 23d.

In the present embodiment too, each bypass diode is connected in such a manner that solar cell strings connected in parallel to the bypass diode do not receive application of a reverse bias voltage from the other solar cell strings.

In the present embodiment too, since the solar cell module 7 is divided into the first solar cell group 101 and the second solar cell group 102 in the y direction, the number of solar cells of solar cell strings connected in parallel to one bypass diode can be reduced. Consequently, it is possible to reduce the number of solar cells which become unable to contribute to the output of the solar cell module when, for example, a portion of the solar cells of the solar cell groups go into the shade and thus cannot generate power. It is therefore possible to suppress a decrease in the output of the solar cell module.

### [Comparative Example]

FIG. 5 is a schematic plan view of a solar cell module according to a comparative example. As in Example 2, the solar cell module according to this comparative example includes a first solar cell group 101 having six first solar cell strings 8, 9, 10, 11, 12, and 13 and a second solar cell group 102 having six second solar cell strings 14, 15, 16, 17, 18, and 19.

In this comparative example, one bypass diode is disposed in each terminal box as disclosed in PTL 1. Accordingly, three first terminal boxes 23a, 23b, and 23c are disposed at positions overlapping the first solar cell group 101, on the back surface 3a side of the back surface member 3 of the first solar cell group 101 (see FIG. 2). Similarly, three second terminal boxes 23d, 23e, and 23f are disposed at positions overlapping the second solar cell group 102, on the back surface 3a side of the back surface member 3 of the second solar cell group 102.

The first terminal boxes 23a, 23b, and 23c include bypass diodes 30a, 30b, and 30c, respectively so that one bypass diode is disposed in each terminal box. Similarly, the second terminal boxes 23d, 23e, and 23f include bypass diodes 30d, 30e, and 30f, respectively so that one bypass diode is disposed in each terminal box.

In this comparative example, a line member 200 is disposed to connect the first terminal box 23c and the second terminal box 23d which are located at one end in the x direction. The line member 200 is disposed similarly to the second line members 51 to 64. One end of the line member 200 is connected to the bypass diode 30c of the first terminal box 23c. The other end of the line member 200 is connected to the bypass diode 30d of the second terminal box 23d.

The bypass diode 30a is electrically connected between the second line member 51 and the second line member 52. Accordingly, the bypass diode 30a is electrically connected in parallel to the first solar cell strings 8 and 9 which are connected in series via the second line member 57. The bypass diode 30b is electrically connected between the second line member 52 and the second line member 53. Accordingly, the bypass diode 30b is electrically connected in parallel to the first solar cell strings 10 and 11 which are connected in series via the second line member 56. The bypass diode 30c is electrically connected between the second line member 53 and the line member 200. Accordingly, the bypass diode 30c is electrically connected in parallel to the first solar cell strings 12 and 13 which are connected in series via the second line member 55.

The bypass diode 30d is electrically connected between the line member 200 and the second line member 62. Accordingly, the bypass diode 30d is electrically connected in parallel to the second solar cell strings 14 and 15 which are connected in series via the second line member 60. The bypass diode 30e is electrically connected between the second line member 62 and the second line member 63. Accordingly, the bypass diode 30e is electrically connected in parallel to the second solar cell strings 16 and 17 which are connected in series via the second line member 59. The bypass diode 30f is electrically connected between the second line member 63 and the second line member 64. Accordingly, the bypass diode 30f is electrically connected in parallel to the second solar cell strings 18 and 19 which are connected in series via the second line member 58.

As illustrated in FIG. 5, a solar cell module 201 according to the comparative example requires a space for disposing the line member 200 in the region interposed between the front surface member 2 and the back surface member 3, thus increasing the area of the solar cell module 201. In order to avoid the increase in the area of the solar cell module 201, one may consider locating the line member 200 in the region where the solar cells 1 are disposed. In this case, the line member 200 is disposed between the solar cells 1 and the back surface member 3 (see FIG. 2). The typical manufacturing process of the solar cell module includes: disposing a first sheet on the front surface member 2 to serve as the filler layer 5a on the front surface member 2 side; disposing solar cells connected by line members, on the first sheet; disposing a second sheet on the solar cells to serve as the filler layer 5b on the back surface member 3 side; disposing the back surface member 3 on the second sheet to make a laminate structure; and applying a pressure to the laminate structure, so as to manufacture the solar cell module. If the line member 200 is present at a position overlapping the solar cells 1 at the time of the pressure application, the line member 200 comes in contact with the solar cells 1, resulting in concentration of a load on the solar cells 1. As a consequence, cell cracking may occur in the solar cells 1.

To prevent such cell cracking in the solar cells 1, the line member 200 needs to be located in a region where solar cells 1 are not disposed. Therefore, if the first terminal box 23c and the second terminal box 23d are to be connected by the line member 200 as in the solar cell module 201 of the comparative example, a space for disposing the line member 200 is required, resulting in an increase in the area of the solar cell module 201.

In Example 2, the first terminal box 23c and the second terminal box 23d are electrically connected by the external line 20, thus requiring no space for disposing a new line member in the solar cell module. It is therefore possible to suppress an increase in the area of the solar cell module.

### [Embodiment 3]

FIG. 4 is a schematic plan view of a solar cell module according to Embodiment 3. In the present embodiment, a first solar cell group 101, a second solar cell group 102, and a third solar cell group 103 are arrayed in the x direction. The first solar cell group 101 includes three first solar cell strings 8, 9, and 10. The second solar cell group 102 includes four second solar cell strings 14, 15, 16, and 17. The third solar cell group 103 includes three third solar cell strings 42, 43, and 44.

The first solar cell group 101 is configured by electrically connecting the three first solar cell strings 8, 9, and 10 arrayed in the x direction, with second line members 71, 72, and 81. The second solar cell group 102 is configured by electrically connecting the four second solar cell strings 14, 15, 16, and 17 arrayed in the x direction, with second line members 73, 74, and 79. The third solar cell group 103 is configured by electrically connecting the three third solar cell strings 42, 43, and 44 arrayed in the x direction, with second line members 75, 76, and 77.

The first solar cell string 10 of the first solar cell group 101 and the second solar cell string 14 of the second solar cell group 102 are electrically connected by a second line member 80. The second solar cell string 17 of the second solar cell group 102 and the third solar cell string 42 of the third solar cell group 103 are electrically connected by a second line member 78.

One end of the first solar cell string 8 in the y direction is electrically connected to the second line member 71 by the first line members 4. The other end of the first solar cell string 8 in the y direction is electrically connected to the second line member 81 by the first line members 4. One end of the first solar cell string 9 in the y direction is electrically connected to the second line member 72 by the first line members 4. The other end of the first solar cell string 9 in the y direction is electrically connected to the second line member 81 by the first line members 4. One end of the first solar cell string 10 in the y direction is electrically connected to the second line member 72 by the first line members 4. The other end of the first solar cell string 10 in the y direction is electrically connected to the second line member 80 by the first line members 4.

One end of the second solar cell string 14 in the y direction is electrically connected to the second line member 73 by the first line members 4. The other end of the second solar cell string 14 in the y direction is electrically connected to the second line member 80 by the first line members 4. One end of the second solar cell string 15 in the y direction is electrically connected to the second line member 73 by the first line members 4. The other end of the second solar cell string 15 in the y direction is electrically connected to the second line member 79 by the first line members 4.

One end of the second solar cell string 16 in the y direction is electrically connected to the second line member 74 by the first line members 4. The other end of the second solar cell string 16 in the y direction is electrically connected to the second line member 79 by the first line members 4. One end of the second solar cell string 17 in the y direction is electrically connected to the second line member 74 by the first line members 4. The other end of the second solar cell string 17 in the y direction is electrically connected to the second line member 78 by the first line members 4.

One end of the third solar cell string 42 in the y direction is electrically connected to the second line member 75 by the first line members 4. The other end of the third solar cell string 42 in the y direction is electrically connected to the second line member 78 by the first line members 4. One end of the third solar cell string 43 in the y direction is electrically connected to the second line member 75 by the first line members 4. The other end of the third solar cell string 43 in the y direction is electrically connected to the second line member 77 by the first line members 4. One end of the third solar cell string 44 in the y direction is electrically connected to the second line member 76 by the first line members 4. The other end of the third solar cell string 44 in the y direction is electrically connected to the second line member 77 by the first line members 4.

In the present embodiment, a first terminal box 24 is disposed at a position overlapping the first solar cell group 101, on the back surface 3a side of the back surface member 3 of the first solar cell group 101 (see FIG. 2). Similarly, a second terminal box 25 is disposed at a position overlapping the second solar cell group 102, on the back surface 3a side of the back surface member 3 of the second solar cell group 102. Similarly, a third terminal box 26 is disposed at a position overlapping the third solar cell group 103, on the back surface 3a side of the back surface member 3 of the third solar cell group 103. In the present embodiment too, each terminal box is disposed at a position overlapping solar cells 1 located at the periphery of the solar cell module 7.

The first terminal box 24 includes bypass diodes 30a and 30b. The second terminal box 25 includes bypass diodes 30c and 30d. The third terminal box 26 includes a bypass diode 30e.

An external line 20 is disposed to connect the first terminal box 24 and the second terminal box 25. The external line 20 is disposed on the back surface 3a side of the back surface member 3 (see FIG. 2). One end of the external line 20 is connected to the bypass diode 30b of the first terminal box 24. The other end of the external line 20 is connected to the bypass diode 30c of the second terminal box 25.

Another external line 20 is disposed to connect the second terminal box 25 and the third terminal box 26. The external line 20 is disposed on the back surface 3a side of the back surface member 3 (see FIG. 2). One end of the external line 20 is connected to the bypass diode 30d of the second terminal box 25. The other end of the external line 20 is connected to the bypass diode 30e of the third terminal box 26.

The bypass diode 30a is electrically connected between the second line member 71 and the second line member 72. Accordingly, the bypass diode 30a is electrically connected in parallel to the solar cell subgroup formed by the first solar cell strings 8 and 9 which are connected in series via the second line member 81. The bypass diode 30b is electrically connected between the second line member 72 and the second line member 73. Accordingly, the bypass diode 30b is electrically connected in parallel to the solar cell subgroup formed by the first solar cell string 10 and the second solar cell string 14 which are connected in series via the second line member 80. The bypass diode 30c is electrically connected between the second line member 73 and the second line member 74. Accordingly, the bypass diode 30c is electrically connected in parallel to the solar cell subgroup formed by the second solar cell strings 15 and 16 which are connected in series via the second line member 79.

The bypass diode 30d is electrically connected between the second line member 74 and the second line member 75. Accordingly, the bypass diode 30d is electrically connected in parallel to the solar cell subgroup formed by the second solar cell string 17 and the third solar cell string 42 which are connected in series via the second line member 78. The bypass diode 30e is electrically connected between the second line member 75 and the second line member 76. Accordingly, the bypass diode 30e is electrically connected in parallel to the solar cell subgroup formed by the third solar cell strings 43 and 44 which are connected in series via the second line member 77.

In the present embodiment too, each bypass diode is connected in such a manner that the solar cell strings connected in parallel to the bypass diode do not receive application of a reverse bias voltage from the other solar cell strings.

In the present embodiment, since the solar cell module 7 is divided into the first solar cell group 101, the second solar cell group 102, and the third solar cell group 103 in the x direction, the number of solar cells of the solar cell strings connected in parallel to a bypass diode can be reduced. Consequently, it is possible to reduce the number of solar cells which become unable to contribute to the output of the solar cell module when, for example, a portion of the solar cells of the solar cell groups go into the shade and thus cannot generate power. It is therefore possible to suppress a decrease in the output of the solar cell module.

In the present embodiment, the electrical connection between the first terminal box 24 and the second terminal box 25 and the electrical connection between the second terminal box 25 and the third terminal box 2 6 are made by the external lines 2 0, thus requiring no space for disposing a new line member in the region interposed between the front surface member 2 and the back surface member 3. It is therefore possible to suppress an increase in the area of the solar cell module.

It is to be noted that in each of the above embodiments, the y direction is the direction in which the solar cells are arrayed in the solar cell strings, whereas the x direction is the direction in which the solar cell strings are arrayed in the solar cell module.

Each of the above embodiments has illustrated, as an example, a solar cell module having the front surface 1a side of the solar cells 1 as the light receiving surface side. The present invention, however, is not limited to this. For example, the present invention may be implemented as a bifacial solar cell module which receives light from both the front surface 1a side and the back surface 1b side of the solar cells 1. In this case, each terminal box may be disposed at a position not overlapping the solar cells 1. For example, each terminal box may be located more outwardly of the solar cells located at the periphery of the solar cell module.

Although the present invention has been described and illustrated in detail, it is clearly understood that the same is by way of example only and is not to be taken by way of limitation, the scope of the present invention being limited only by the terms of the appended claims.

### [Reference Signs List]

- 1: solar cell
- 1a: front surface
- 1b: back surface
- 2: front surface member
- 3: back surface member
- 3a: back surface
- 4: first line member
- 5, 5a, 5b: filler layer
- 6: finger electrode
- 7: solar cell module
- 8-13: first solar cell string
- 14-19: second solar cell string
- 20: external line
- 21: first terminal box
- 22: second terminal box
- 23a, 23b, 23c: first terminal box
- 23d, 23e, 23f: second terminal box
- 24: first terminal box
- 25: second terminal box
- 26: third terminal box
- 30a-30f: bypass diode
- 31-33, 35-41: second line member
- 34: third line member
- 42-44: third solar cell string
- 51-64: second line member
- 71-81: second line member
- 101: first solar cell group
- 102: second solar cell group
- 103: third solar cell group
- 200: line member
- 201: solar cell module

## Claims

1. A solar cell module (7) comprising:
a first solar cell group (101) including a plurality of solar cells (1) connected by a plurality of first line members (4);
a second solar cell group (102) including a plurality of solar cells (1) connected by a plurality of first line members (4);
a front surface member (2) disposed on a front surface (1a) side of the first solar cell group (101) and the second solar cell group (102);
a back surface member (3) disposed on a back surface (1b, 3a) side of the first solar cell group (101) and the second solar cell group (102);
one or more first terminal boxes (21, 24) disposed on a back surface (1b, 3a) side of the back surface member (3) and each including one or more bypass diodes (30a-30f) connected to the first solar cell group (101);
one or more second terminal boxes (22, 25) disposed on the back surface (1b, 3a) side of the back surface member (3) and each including one or more bypass diodes (30a-30f) connected to the second cell group (102); and
an external line (20) disposed on the back surface (1b, 3a) side of the back surface member (3) and electrically connecting at least one first terminal box (21, 24) among the one or more first terminal boxes (21, 24) and at least one second terminal box (22, 25) among the one or more second terminal boxes (22, 25),
wherein the first solar cell group (101) includes a plurality of first solar cell strings (8-12) each of which includes, among the plurality of solar cells (1), a plurality of solar cells (1) connected by one of the plurality of first line members (4), the plurality of first solar cell strings (8-12) being connected by a second line member (31-33, 35-41, 71-77, 79, 81),
the second solar cell group (102) includes a plurality of second solar cell strings (14-19) each of which includes, among the plurality of solar cells (1), a plurality of solar cells (1) connected by one of the plurality of first line members (4), the plurality of second solar cell strings (14-19) being connected by a second line member (31-33, 35-41, 71-77, 79, 81), and
one of the plurality of first solar cell strings (8-12) included in the first solar cell group (101) and one of the plurality of second solar cell strings (14-19) included in the second solar cell group (102) are connected by a third line member (34, 80).

2. The solar cell module (7) according to claim 1,
wherein a total number of bypass diodes (30a-30f) included in each of the one or more first terminal boxes (21, 24) is different from a total number of bypass diodes (30a-30f) included in each of the one or more second terminal boxes (22, 25).

3. The solar cell module (7) according to claim 1 or claim 2,
wherein an output terminal of one of the one or more bypass diodes (30a-30f) included in one of the one or more first terminal boxes (21, 24) and an input terminal of one of the one or more bypass diodes (30a-30f) included in one of the one or more second terminal boxes (22, 25) are connected in series by the external line member, and
a total number of bypass diodes (30a-30f) included in each of the one or more first terminal boxes (21, 24) is greater than a total number of bypass diodes (30a-30f) included in each of the one or more second terminal boxes(22, 25).

4. The solar cell module (7) according to any one of claims 1 to 3,
wherein the first solar cell group (101) includes an odd number of the first solar cell strings (8-12), and the second solar cell group (102) includes an odd number of the second solar cell strings (15-19).

5. The solar cell module (7) according to claim 1,
wherein the first solar cell group (101) includes an odd number of the first solar cell strings (8-10), and the second solar cell group (102) includes an even number of the second solar cell strings (14-17).

6. The solar cell module (7) according to any one of claims 1 to 5,
wherein, in plan view of the plurality of solar cells (1), the one or more first terminal boxes (21, 24) are each disposed at a position overlapping the first solar cell group (101), and the one or more second terminal boxes (22, 25) are each disposed at a position overlapping the second solar cell group (102).

7. The solar cell module (7) according to any one of claims 1 to 6,
wherein, in plan view of the plurality of solar cells (1), the one or more first terminal boxes (21, 24) and the one or more second terminal boxes (22, 25) are each disposed at a position overlapping, among the plurality of solar cells (1), at least one solar cell (1) located at a periphery of the solar cell module (7).

## Patentansprüche

1. Ein Solarzellenmodul (7), das Folgendes umfasst:
eine erste Solarzellengruppe (101), die eine Vielzahl von Solarzellen (1) beinhaltet, die durch eine Vielzahl von ersten Leitungselementen (4) verbunden sind;
eine zweite Solarzellengruppe (102), die eine Vielzahl von Solarzellen (1) beinhaltet, die durch eine Vielzahl von ersten Leitungselementen (4) verbunden sind;
ein Stirnflächenelement (2), das auf einer Seite einer Stirnfläche (1a) der ersten Solarzellengruppe (101) und der zweiten Solarzellengruppe (102) angeordnet ist;
ein Rückflächenelement (3), das auf einer Seite einer Rückfläche (1b, 3a) der ersten Solarzellengruppe (101) und der zweiten Solarzellengruppe (102) angeordnet ist;
einen oder mehrere erste Anschlusskästen (21, 24), die auf einer Seite der Rückfläche (1b, 3a) des Rückflächenelements (3) angeordnet sind und jeweils eine oder mehrere Bypass-Dioden (30a - 30f) beinhalten, die mit der ersten Solarzellengruppe (101) verbunden sind;
einen oder mehrere zweite Anschlusskästen (22, 25), die auf der Seite der Rückfläche (1b, 3a) des Rückflächenelements (3) angeordnet sind und jeweils eine oder mehrere Bypass-Dioden (30a - 30f) beinhalten, die mit der zweiten Zellgruppe (102) verbunden sind; und
eine externe Leitung (20), die auf der Seite der Rückseite (1b, 3a) des Rückflächenelements (3) angeordnet ist und die mindestens einen ersten Anschlusskasten (21, 24) unter dem einen oder den mehreren ersten Anschlusskästen (21, 24) und mindestens einen zweiten Anschlusskasten (22, 25) unter dem einen oder den mehreren zweiten Anschlusskästen (22, 25) elektrisch verbindet,
wobei die erste Solarzellengruppe (101) eine Vielzahl von ersten Solarzellenketten (8 - 12) beinhaltet, von denen jede unter der Vielzahl von Solarzellen (1) eine Vielzahl von Solarzellen (1) beinhaltet, die durch eines von der Vielzahl von ersten Leitungselementen (4) verbunden sind, wobei die Vielzahl von ersten Solarzellenketten (8 - 12) durch ein zweites Leitungselement (31 - 33, 35 - 41, 71 - 77, 79, 81) verbunden ist,
wobei die zweite Solarzellengruppe (102) eine Vielzahl von zweiten Solarzellenketten (14 - 19) beinhaltet, von denen jede unter der Vielzahl von Solarzellen (1) eine Vielzahl von Solarzellen (1) beinhaltet, die durch eines von der Vielzahl von ersten Leitungselementen (4) verbunden sind, wobei die Vielzahl von zweiten Solarzellenketten (14 - 19) durch ein zweites Leitungselement (31 - 33, 35 - 41, 71 - 77, 79, 81) verbunden ist, und
wobei eine von mehreren ersten Solarzellenketten (8 - 12), die in der ersten Solarzellengruppe (101) enthalten sind, und eine von mehreren zweiten Solarzellenketten (14 - 19), die in der zweiten Solarzellengruppe (102) enthalten sind, durch ein drittes Leitungselement (34, 80) verbunden sind.

2. Das Solarzellenmodul (7) nach Anspruch 1,
wobei eine Gesamtanzahl von Bypass-Dioden (30a - 30f), die in jedem von einem oder mehreren ersten Anschlusskästen (21, 24) enthalten ist, sich von einer Gesamtanzahl von Bypass-Dioden (30a - 30f) unterscheidet, die in jedem von einem oder mehreren zweiten Anschlusskästen (22, 25) enthalten ist.

3. Das Solarzellenmodul (7) nach Anspruch 1 oder Anspruch 2,
wobei ein Ausgangsanschluss von einer der einen oder mehreren Bypass-Dioden (30a - 30f), die in einem vom einem oder mehreren ersten Anschlusskästen (21, 24) enthalten ist, und ein Eingangsanschluss von einer der einen oder mehreren Bypass-Dioden (30a - 30f), die in einem von einem oder mehreren zweiten Anschlusskästen (22, 25) enthalten ist, durch das externe Leitungselement in Reihe geschaltet sind, und wobei
eine Gesamtanzahl von Bypass-Dioden (30a - 30f), die in jedem von einem oder mehreren ersten Anschlusskästen (21, 24) enthalten sind, größer ist als eine Gesamtanzahl von Bypass-Dioden (30a - 30f), die in jedem von einem oder mehreren zweiten Anschlusskästen (22, 25) enthalten sind.

4. Das Solarzellenmodul (7) nach irgendeinem der Ansprüche von 1 bis 3,
wobei die erste Solarzellengruppe (101) eine ungerade Anzahl von ersten Solarzellenketten (8 - 12) beinhaltet, und die zweite Solarzellengruppe (102) eine ungerade Anzahl von zweiten Solarzellenketten (15 - 19) beinhaltet.

5. Das Solarzellenmodul (7) nach Anspruch 1,
wobei die erste Solarzellengruppe (101) eine ungerade Anzahl von ersten Solarzellenketten (8-10) beinhaltet, und die zweite Solarzellengruppe (102) eine gerade Anzahl von zweiten Solarzellenketten (14-17) beinhaltet.

6. Das Solarzellenmodul (7) nach irgendeinem der Ansprüche von 1 bis 5,
wobei, in Draufsicht auf die Vielzahl von Solarzellen (1), der eine oder die mehreren ersten Anschlusskästen (21, 24) jeweils an einer Position angeordnet sind, die die erste Solarzellengruppe (101) überlappt, und der eine oder die mehreren zweiten Anschlusskästen (22, 25) jeweils an einer Position angeordnet sind, die die zweite Solarzellengruppe (102) überlappt.

7. Das Solarzellenmodul (7) nach irgendeinem der Ansprüche von 1 bis 6, wobei, in Draufsicht auf die Vielzahl von Solarzellen (1), der eine oder die mehreren ersten Anschlusskästen (21, 24) und der eine oder die mehreren zweiten Anschlusskästen (22, 25) jeweils an einer Position angeordnet sind, die unter der Vielzahl von Solarzellen (1) mindestens eine Solarzelle (1) überlappt, die sich an einer Peripherie des Solarzellenmoduls (7) befindet.

## Revendications

1. Un module de cellules solaires (7) comprenant :
un premier groupe de cellules solaires (101) incluant une pluralité de cellules solaires (1) reliées par une pluralité de premiers éléments de ligne (4) ;
un deuxième groupe de cellules solaires (102) incluant une pluralité de cellules solaires (1) reliées par une pluralité de premiers éléments de ligne (4) ;
un élément de surface avant (2) disposé sur un côté de la surface avant (1a) du premier groupe de cellules solaires (101) et du deuxième groupe de cellules solaires (102) ;
un élément de surface arrière (3) disposé sur un côté de la surface arrière (1b, 3a) du premier groupe de cellules solaires (101) et du deuxième groupe de cellules solaires (102) ;
une ou plusieurs premières boîtes à bornes (21, 24) disposées sur un côté de la surface arrière (1b, 3a) de l'élément de surface arrière (3) et incluant chacune une ou plusieurs diodes de dérivation (30a - 30f) connectées au premier groupe de cellules solaires (101) ;
une ou plusieurs deuxièmes boîtes à bornes (22, 25) disposées sur le côté de la surface arrière (1b, 3a) de l'élément de surface arrière (3) et incluant chacune une ou plusieurs diodes de dérivation (30a - 30f) connectées au deuxième groupe de cellules (102) ; et
une ligne externe (20) disposée sur le côté de la surface arrière (1b, 3a) de l'élément de surface arrière (3) et reliant électriquement au moins une première boîte à bornes (21, 24) parmi la ou les premières boîtes à bornes (21, 24) et au moins une deuxième boîte à bornes (22, 25) parmi la ou les deuxièmes boîtes à bornes (22, 25),
sachant que le premier groupe de cellules solaires (101) inclut une pluralité de premières chaînes de cellules solaires (8 - 12), dont chacune inclut, parmi la pluralité de cellules solaires (1), une pluralité de cellules solaires (1) connectées par un élément de la pluralité de premiers éléments de ligne (4), la pluralité de premières chaînes de cellules solaires (8 - 12) étant connectée par un deuxième élément de ligne (31 - 33, 35 - 41, 71 - 77, 79, 81),
sachant que le deuxième groupe de cellules solaires (102) inclut une pluralité de deuxièmes chaînes de cellules solaires (14 - 19), dont chacune inclut, parmi la pluralité de cellules solaires (1), une pluralité de cellules solaires (1) connectées par un élément de la pluralité de premiers éléments de ligne (4), la pluralité de deuxièmes chaînes de cellules solaires (14 - 19) étant connectée par un deuxième élément de ligne (31 - 33, 35 - 41, 71 - 77, 79, 81), et que
l'une de la pluralité des premières chaînes de cellules solaires (8 - 12) incluses dans le premier groupe de cellules solaires (101) et l'une de la pluralité des deuxièmes chaînes de cellules solaires (14 - 19) incluses dans le deuxième groupe de cellules solaires (102) sont reliées par un troisième élément de ligne (34, 80).

2. Le module de cellules solaires (7) d'après la revendication 1,
sachant que le nombre total de diodes de dérivation (30a - 30f) incluses dans chacune de la ou des premières boîtes à bornes (21, 24) est différent du nombre total de diodes de dérivation (30a - 30f) incluses dans chacune de la ou des deuxièmes boîtes à bornes (22, 25).

3. Le module de cellules solaires (7) d'après la revendication 1 ou la revendication 2,
sachant qu'une borne de sortie de l'une de la ou des diodes de dérivation (30a - 30f) incluses dans l'une de la ou des premières boîtes à bornes (21, 24) et la borne d'entrée de l'une de la ou des diodes de dérivation (30a - 30f) incluses dans l'une de la ou des deuxièmes boîtes à bornes (22, 25) sont connectées en série par l'élément de ligne externe, et
un nombre total de diodes de dérivation (30a - 30f) incluses dans chacune de la ou des premières boîtes à bornes (21, 24) est supérieur à un nombre total de diodes de dérivation (30a - 30f) incluses dans chacune de la ou des deuxièmes boîtes à bornes (22, 25).

4. Le module de cellules solaires (7) d'après l'une quelconque des revendications de 1 à 3,
sachant que le premier groupe de cellules solaires (101) inclut un nombre impair de premières chaînes de cellules solaires (8 - 12), et que le deuxième groupe de cellules solaires (102) inclut un nombre impair de deuxièmes chaînes de cellules solaires (15 - 19).

5. Le module de cellules solaires (7) d'après la revendication 1,
sachant que le premier groupe de cellules solaires (101) inclut un nombre impair de premières chaînes de cellules solaires (8 - 10), et que le deuxième groupe de cellules solaires (102) inclut un nombre pair de deuxièmes chaînes de cellules solaires (14 - 17).

6. Le module de cellules solaires (7) d'après l'une quelconque des revendications de 1 à 5,
sachant que, dans une vue en plan de la pluralité de cellules solaires (1), la ou les premières boîtes à bornes (21, 24) sont disposées chacune à une position chevauchant le premier groupe de cellules solaires (101), et que la ou les deuxièmes boîtes à bornes (22, 25) sont disposées chacune à une position chevauchant le deuxième groupe de cellules solaires (102).

7. Le module de cellules solaires (7) d'après l'une quelconque des revendications de 1 à 6,
sachant que, dans une vue en plan de la pluralité de cellules solaires (1), la ou les premières boîtes à bornes (21, 24) et la ou les deuxièmes boîtes à bornes (22, 25) sont disposées chacune à une position chevauchant, parmi la pluralité de cellules solaires (1), au moins une cellule solaire (1) située à une périphérie du module de cellules solaires (7).
